(19)

**Europäisches Patentamt**

**European Patent Office**

**Office européen des brevets**

(11)  **EP 4 621 667 A1**

(12)  **EUROPEAN PATENT APPLICATION**

(43) Date of publication:
24.09.2025 Bulletin 2025/39

(21) Application number: 24164421.0

(22) Date of filing: 19.03.2024

(51) International Patent Classification (IPC):
*G06N 20/00* (2019.01)    *G06N 7/01* (2023.01)
*G06N 5/01* (2023.01)

(52) Cooperative Patent Classification (CPC):
**G06N 20/00; G06N 5/01; G06N 7/01**

---

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Robert Bosch GmbH
70442 Stuttgart (DE)**

(72) Inventors:
- **Flynn, Hamish
70182 Stuttgart (DE)**
- **Reeb, David
71272 Renningen (DE)**

Remarks:
Amended claims in accordance with Rule 137(2)
EPC.

---

(54)  **SYSTEM AND METHOD FOR OPTIMIZATION PARAMETERS OF A TARGET FUNCTION**

(57)     A system and method are provided for performing Bayesian optimization in respect of a set of parameters of a target function, such as a black-box function. The Bayesian optimization may be performed iteratively until a stopping criterion is reached. The stopping criterion may be based on an upper and lower confidence bound function and may be reached when a difference between an optimum of the upper confidence bound function and the optimum of the lower confidence bound function reaches or falls below an accuracy target. The stopping criterion may be evaluated by determining an optimum of a respective upper or lower confidence bound function over all of the parameter space. Thereby, it may be ensured that the stopping criterion is met not just based on the explored points but considering the parameter space's entire range.

Fig. 1

EP 4 621 667 A1

## Description

### Field

The presently disclosed subject matter relates to a computer-implemented method and processor system for performing Bayesian optimization in respect of a set of parameters of a target function, such as a black-box function. The presently disclosed subject matter further relates to a computer-readable medium comprising data representing a computer program comprising instructions for causing a processor system to perform the method.

### Background

Many technical processes and technical systems can be subject to optimization. Such optimization may involve finding optimal parameters of the technical process or system to improve its functioning, e.g., in terms of efficiency, accuracy, reliability, etc. It is known to model a technical process or system and to derive optimal parameters from such modelling. For example, the technical process or system may be mathematically modelled, and a known optimization technique, for example a derivate-based optimization technique such as gradient descent, may be applied to the mathematical model to find optimal parameters for the technical process or system.

However, there are classes of technical processes or systems which cannot be easily modelled. Effectively, such technical processes or systems represent 'black-box' functions of which their output can be observed given a set of parameters as input, but of which the inner mechanisms may not be easily modelled. An example of such a black-box function is a manufacturing process, where the resulting manufactured product may be measured but intricate details of the manufacturing process may remain hidden. Another example is the hyperparameter tuning of a machine learning model, which may represent a black-box function since the direct relationship between the hyperparameters and the model's performance metric may be complex and unknown. Yet another example is the optimization of energy consumption in smart grids, in which the intricate interactions between components of the smart grid may not be known.

It is known to use iterative methods optimize the parameters of such black-box functions. However, as there may be no (mathematical) model available for such a black-box function, the black-box function may need to be evaluated in the real world to determine whether a set of parameters results in the desired functioning, e.g., in terms of efficiency, accuracy, reliability, etc. The real-world evaluation of a black-box function for a set of parameters may be very time-consuming and/or resource-intensive. For example, to evaluate a set of parameters of a manufacturing process, a manufacturing line may have to be (re)configured in accordance with the parameters, the manufacturing line may have to be started and at least one manufactured product may have to be completely manufactured. Such an evaluation may take hours or even days.

It is therefore desirable to be able to optimize the parameters of a black-box function with the least amount of evaluations of the black-box function. Given that derivate-based optimization techniques cannot be used due to the unavailability of a (mathematical) model, other techniques have been developed.

Bayesian optimization is a known technique for optimizing parameters of such black-box functions. This technique involves building a probabilistic model, sometimes also referred to as a surrogate model, of the black-box function based on existing data points and using this model to predict the most promising areas to explore next. Bayesian optimization effectively balances the exploration of new parameter regions with the exploitation of known good sets of parameters, making it particularly useful for optimizing functions that are expensive or time-consuming to evaluate.

However, a challenge with Bayesian optimization is determining when to stop the optimization process. Because evaluating the black-box function is costly, running the optimization for too long can lead to excessive costs. Conversely, stopping too early may result in a suboptimal set of parameters. Known criteria for stopping Bayesian optimization include ceasing the optimization when no improvement is seen over a certain number of steps, or when a predefined computational budget is reached.

Reference [1], which focuses on Bayesian optimization for Hyperparameter Optimization of machine learning models, suggests a stopping criterion that involves comparing a maximum plausible regret (the regret upper bound used in [1]) at each iteration to an adaptive accuracy target.

Disadvantageously, this stopping criterion has been found to be too lenient, leading to unnecessary evaluations and increased evaluation costs. Furthermore, reference [1] employs non-rigorous confidence intervals, scaled down from their rigorously proven values by a certain factor such as 5; this obviate guarantees for the stopping rule proposed in [1].

It may be desirable to be able to obtain an improved stopping criterion for the Bayesian optimization of a target function, such as the aforementioned black-box function (e.g., a manufacturing process, hyperparameter tuning, smart grid operation, etc.).

### References

## EP 4 621 667 A1

[1] "Automatic Termination for Hyperparameter Optimization",
https://arxiv.org/abs/2104.081 66

## Summary

In accordance with a first aspect of the present disclosure, as defined by claim 1, a computer-implemented method is provided for performing Bayesian optimization in respect of a set of parameters of a target function, such as a black-box function. In accordance with a further aspect of the present disclosure, as defined by claim 14, a computer-readable medium is provided comprising a computer program comprising instructions for causing a processor system to perform the method. In accordance with a further aspect of the present disclosure, as defined by claim 15, a processor system is provided which is configured to perform the aforementioned Bayesian optimization.

The above measures may involve performing Bayesian optimization in respect of a set of parameters of a target function. The target function may typically be a black-box function of which the inner mechanisms may not be easily modelled. However, the above measures may also be applied to the Bayesian optimization of target functions which may not necessarily be considered as 'black-box' functions. As may be known per se, the Bayesian optimization may involve optimizing the set of parameters by evaluating the target function using different points in the parameter space as input. Each of these points may represent a different set of parameters. The evaluation of the target function may involve determining the output of the target function for a particular set of parameters. Determining the output of the target function may involve executing the technical process or operating the technical system representing the target function. For example, a manufacturing process may be configured with a set of process parameters and then executed. Another example is that a machine learning model may be trained using a set of hyperparameters, a smart grid may be operated in accordance with a set of operational parameters for a certain time period, etc.

As may also be known per se, the optimization may be an iterative process in which, in a respective iteration, a new point may be selected in the parameter space based on a dataset which comprises pairwise data tuples each comprising a previous input to the target function and a previous output from the target function. The dataset may thus represent the set of known function inputs and outputs, and may also be referred to as a historical dataset, an observation history, or an evaluation history. The selection of the new point may be based on known techniques, for example based on a modelling of the target function which is updated each iteration based on the dataset. The target function may then be evaluated using the new point as new input to obtain a new output of the target function. As indicated above, such evaluation may involve the execution of a technical process, the operation of a technical system, etc. The new input and the new output may then be added to the dataset, thereby incrementally expanding the dataset. It is noted that these steps may be performed sequentially across iterations but may be performed in a different order in a given iteration. For example, the iteration may start with augmenting the dataset based on the output of the target function in a previous iteration and end with the target function being evaluated for a new point.

The above measures provide a stopping criterion for such otherwise known Bayesian optimization. The stopping criterion may be evaluated periodically, typically at each iteration (e.g., at an end or a start). The stopping criterion may in its broadest form comprise a comparison which is similar to [1], except that another term is used instead of the regret upper bound used in [1] and that the inventors have devised that the accuracy target may be any type of accuracy target, adaptive, e.g., as [1], fixed, or otherwise.

The stopping criterion in accordance with the above measures may be based on an upper confidence bound (UCB) function and a lower confidence bound (LCB) function. Such confidence bound functions may be known per se and may be configured to determine a confidence bound for a point in the parameter space using the dataset as input. Effectively, these confidence bound functions may utilize the historical data to compute a statistical range for each point in the parameter space, encapsulating the uncertainty or reliability of the predictions at that point. The upper bound may represent the highest plausible value, considering the uncertainty, while the lower bound may indicate the lowest plausible value, considering the uncertainty.

The stopping criterion may be based on the *difference* between the optimum of the UCB and the optimum of the LCB. Such an optimum over the parameter space may for example be a maximum, by which the difference is between the maximum of the UCB and the maximum of the LCB. Likewise, the optimum may be a minimum, by which the difference is between the minimum of the UCB and the minimum of the LCB. Such a difference between the optimum of the UCB and that of the LCB may encapsulate the range of uncertainty around the optimal function value, attained at a best set of parameters. Specifically, when the gap between the highest plausible performance at a best set of parameters and the lowest plausible performance at a best set of parameters narrows down to or falls below a target accuracy threshold, this may indicate that further exploration is unlikely to yield significantly better results within the desired level of confidence. This approach may effectively balance the need for precision with the practical limits of computational resources and time, aiming to stop the optimization when additional efforts are not expected to substantially improve the already identified best set of parameters.

Interestingly, the inventors have devised a novel approach to evaluating the stopping criterion which involves determining an optimum of the UCB and an optimum of the LCB over *all* of the parameter space. Unlike the method described in [1], where in the case of minimization the UCB is only evaluated over previously evaluated input points, by determining an optimum of the UCB over all of the parameter space, a lower minimum of the UCB may be found; in the case of maximization, unlike the method described in [1] which would evaluate the LCB only over previously evaluated input points, by determining an optimum of the LCB over all of the parameter space, a higher maximum of the LCB may be found. This more comprehensive evaluation of the UCB respectively LCB may decrease the difference between the optimum of the UCB and the optimum of the LCB to yield an earlier stopping of the optimization process. Thereby, it may be ensured that the stopping criterion is met not just based on the explored points but considering the parameter space's entire range. This may lead to a more efficient optimization by avoiding unnecessary evaluations while still maintaining a high level of confidence in the optimality (up to a certain accuracy) of the solution.

Optionally, evaluating the upper respectively the lower confidence bound function, e.g., at a certain input point, comprises determining a maximum respectively a minimum value of a surrogate model, wherein the surrogate model is configured to approximate the target function, wherein determining the maximum respectively the minimum value comprises maximizing respectively minimizing the surrogate model over a set of feasible surrogate functions. The UCB function and the LCB function may each be based on a surrogate model, which may be an approximation of the target function. Since the surrogate model may be a mathematical model, it may be easier and less resource-intensive to evaluate than the target function itself. The surrogate model may predict the output of the target function based on historical data, e.g., the dataset of data tuples. The term 'surrogate function' may refer to a specific instance of the surrogate model providing a specific approximation of the target function. The surrogate model may be maximized (in case of UCB function) or minimized (in case of LCB FUNCTION) over a set of feasible surrogate functions, meaning that a maximization respectively minimization may be performed which involves comparing and selecting among multiple surrogate functions. Each of these surrogate functions may be feasible in the sense that it may predict the output of the target function in a way which is consistent with the historical dataset, at least to a degree. An example of a surrogate model is a Gaussian Process. An example of a surrogate function may be a specific instance of a Gaussian Process, such as a function drawn from a Gaussian Process. By maximizing respectively minimizing over a set of feasible surrogate functions, the UCB respectively the LCB function may approximate the target function more tightly (i.e., better) since the UCB function and LCB function is based only on *feasible* surrogate functions, which ensures a certain degree of agreement (consistency) with the historical dataset, which in turn may tighten the criteria for stopping. This may result in a more precise determination of when the Bayesian optimization process should halt.

Optionally, the surrogate model is a linear model, wherein the linear model is defined as an inner product of a feature vector and a parameter vector, wherein the feature vector defines a transformation of an input point into a feature space, wherein the parameter vector weighs features in the feature space to obtain an approximated output of the target function, wherein a surrogate function corresponds to the inner product of the feature vector and a parameter vector, wherein a feasible surrogate function corresponds to the inner product of the feature vector and a feasible parameter vector. The surrogate model may take various forms, including a linear model as defined above. An advantage of using a linear model is its simplicity, which may allow the linear model to be efficiently evaluated. A thereto related advantage of a linear model may be its robustness against overfitting or its bounded complexity. In addition, linear models may sometimes be solved analytically, eliminating the need for iterative numerical optimization methods. This may further speed up the optimization process, as the optimal parameter vector of the surrogate model may under some circumstances be found directly or may be found as the solution of a low-dimensional optimization problem. Linear models may also lead to convex optimization problems. Such convex optimization problems may be solved efficiently using (known) convex optimization techniques.

Optionally, the set of feasible surrogate functions is defined as the set of surrogate functions which satisfy both a consistency constraint and an overfitting constraint, wherein the consistency constraint limits the set of feasible surrogate functions to those surrogate functions which generate outputs which are consistent with the previous outputs from the target function, wherein the overfitting constraint restricts a norm, e.g. a Euclidean norm, of the surrogate function or of the parameter vector (in case of a linear model) to remain within a predetermined limit. The consistency constraint may thus enforce a certain degree of consistency with the historical dataset whereas the overfitting constraint may limit overfitting or may limit the complexity of the target function. The inventors have recognized that when the surrogate model is maximized respectively minimized over such a set of feasible surrogate functions when evaluating the UCB respectively LCB function , it may be mathematically proven that the stopping criterion is reached earlier while ensuring a same or similar optimum in the parameter space in the end. In other words, it may be mathematically demonstrated that additional iterations do not further improve the optimality/goodness of the set of parameters beyond a certain limit.

Optionally, the set of feasible surrogate functions is redetermined at each iteration using the previous outputs from the target function. The set of feasible surrogate functions may thus be periodically updated to reflect recent additions to the dataset.

Optionally, the maximum respectively the minimum value of the surrogate model may be determined numerically using a convex optimization technique. Finding an optimum of the surrogate model may constitute a convex optimization problem. Convex optimization problems may be efficiently solved by convex optimization techniques or by convex optimization solver software/tools.

Optionally, a maximum respectively a minimum value of the surrogate model may be determined using an analytical expression for a relaxed version of the upper respectively the lower confidence bound function. Analytical solutions eliminate the need for iterative numerical optimization methods. This may further speed up the optimization process, as the maximum respectively minimum of the surrogate model may be found directly.

Optionally, in an iteration of the iterative optimization, the new point in the parameter space may be selected using the upper confidence bound function if the optimum is the maximum or using the lower confidence bound function if the optimum is the minimum. In other words, the UCB function respectively the LCB function may be used as a so-called acquisition function by which a new point in the parameter space may be identified for evaluation. Since the confidence bound estimates of the confidence bound functions as described above may be tighter, an optimum set of parameters may be found faster than by using other acquisition functions.

Optionally, when the stopping criterion is reached, an estimate of an optimum point in the parameter space may be outputted, wherein the estimate of the optimum point is obtained by determining the maximum of the lower confidence bound over all of the parameter space using the lower confidence bound function if the optimum is the maximum or by determining the minimum of the upper confidence bound over all of the parameter space using the upper confidence bound function if the optimum is the minimum. When the stopping criterion according to the above measures is reached, the surrogate model may provide an adequate approximation of the target function. In other words, the surrogate model may be trusted to well-approximate the target function. As such, the optimal set of parameters, which may for example be used to configure the technical process or the technical system, may be derived from the surrogate model rather than (solely) from a recent evaluation of the target function.

Optionally, an estimate of the output of the target function for the optimum point as input may be outputted, wherein the estimate of the output is obtained by evaluating the lower confidence bound function and the upper confidence bound function for the optimum point, wherein the estimate of the output is preferably outputted in form of the value of the lower confidence bound function at the optimum point and the value of the upper confidence bound at the optimum point or in form of an intermediate value between the values of the lower confidence bound and the upper confidence bound functions at the optimum point. It may also be of interest which output the target function produces when using the optimal set of parameters as input. The surrogate model may be trusted to well-approximate the target function. As such, this output may be derived from the surrogate model, thereby avoiding the need to evaluate the target function using the optimal set of parameters as input.

Optionally, the target function may be configured with a set of parameters which is obtained from the iterative optimization, and optionally, the target function configured with the set of parameters may be executed. Such configuring of the target function may comprise configuring a technical process, e.g., by configuring process parameters of the process itself and/or by configuring operational parameters of systems or devices used in the technical process. Another example is that a technical system may be configured, e.g., by configuring operational parameters of the technical system. The execution of the target function may involve executing the technical process or operating the technical system configured with the set of parameters.

Optionally, the method and processor system may be used to determine a set of parameters for, as the target function:

- execution of a manufacturing process, wherein the set of parameters defines process parameters of the manufacturing process and/or operational parameters of machinery used in the manufacturing process, wherein evaluating the manufacturing process comprises executing the manufacturing process with the set of parameters and characterizing the execution of the manufacturing process and/or a manufactured product of the manufacturing process;
- training of a machine learning model, wherein the set of parameters defines hyperparameters for the training of the machine learning model, wherein evaluating the training of the machine learning model comprises training the machine learning model using the hyperparameters and characterizing the execution of the training and/or the trained machine learning model;
- configuration of a simulation model of a physical system, for example a digital twin of the physical system, or a simulation model of a further and more complex simulation model, wherein the set of parameters defines operational parameters of the simulation model, wherein evaluating the simulation model comprises executing the simulation model using the operational parameters and characterizing a performance and/or an accuracy of the simulation model.

It will be appreciated by those skilled in the art that two or more of the above-mentioned embodiments, implementations, and/or optional aspects of the invention may be combined in any way deemed useful.

Modifications and variations of any computer-implemented method, any computer-readable medium, and any processor system, which correspond to the described modifications and variations of another of such entities, can be carried out by a person skilled in the art on the basis of the present description.

**Brief description of the drawings**

Further details, aspects, and embodiments will be described, by way of example only, with reference to the drawings. Elements in the figures are illustrated for simplicity and clarity and have not necessarily been drawn to scale. In the figures, elements which correspond to elements already described may have the same reference numerals. In the drawings,

**Fig. 1** shows a computer-implemented method of performing Bayesian optimization in respect of a set of parameters of a target function;
**Fig. 2** shows a computer-readable medium having a writable part comprising a computer program according to an embodiment;
**Fig. 3** shows a processor system configured to perform Bayesian optimization in respect of a set of parameters of a target function, wherein the processor system comprises interfaces providing input to, and accessing output from, the target function; and
**Fig. 4** shows plots of confidence bounds obtained by different techniques;

**Reference signs list**

The following list of references and abbreviations is provided for facilitating the interpretation of the drawings and shall not be construed as limiting the claims.

| | |
|---|---|
| 100 | method of performing Bayesian optimization |
| 110 | optimizing a/the set of parameters using Bayesian optimization |
| 120 | selecting a new point in parameter space as new input |
| 130 | evaluating target function to obtain new output |
| 140 | adding new input and new output to dataset |
| 150 | evaluating stopping criterion |
| 160 | stopping criterion reached? |
| 170 | next iteration |
| 180 | outputting set of parameters |
| | |
| 200 | processor system for performing Bayesian optimization |
| 210 | processor |
| 220 | data storage interface |
| 230 | data storage |
| 240 | interface to configure target function with set of parameters |
| 250 | interface to access output of target function |
| | |
| 300 | target function |
| 310 | set of parameters as input |
| 320 | output |
| | |
| 400 | memory card |
| 410 | stored data |
| | |
| 500 | target function |
| 502 | data tuple of input to and output from target function |
| 510 | confidence bound obtained by reference method |
| 520 | confidence bound obtained by convex optimization |
| 530 | confidence bound obtained by analytical solution |

**Detailed description of embodiments**

The present disclosure presents embodiments in detail through drawings and descriptions as representative examples of its underlying principles. It will be appreciated that these specifics are intended to exemplify, rather than limit, the disclosed subject matter. For example, the disclosed subject matter also encompasses any combination of features mentioned in this disclosure or outlined in the various dependent claims. In instances where subject matter is expressed through mathematical formulations, alternative mathematical embodiments can be readily envisaged by those skilled in the field, based on the information provided in this disclosure.

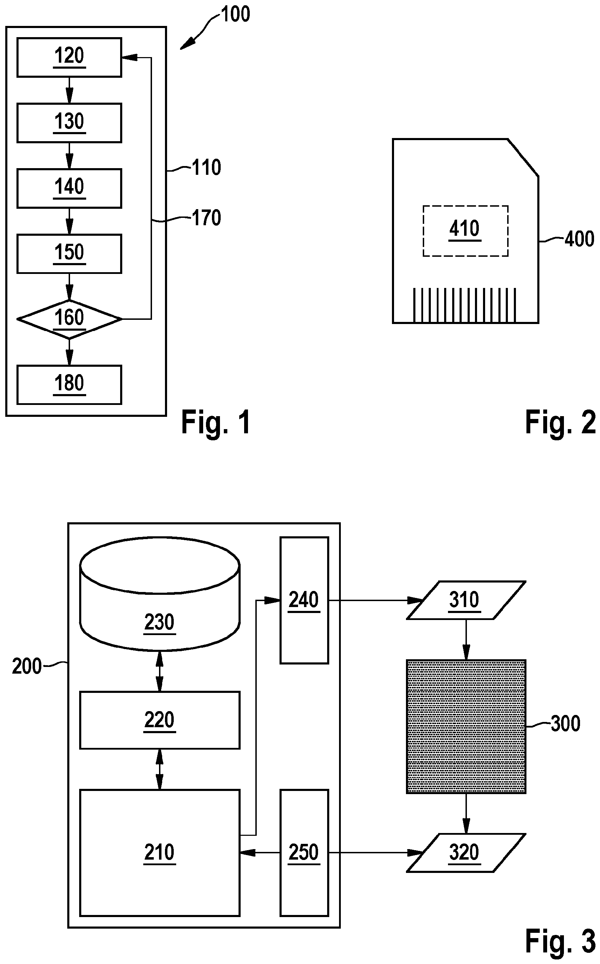

**Fig. 1** shows a computer-implemented method 100 of performing Bayesian optimization in respect of a set of parameters of a target function, being for example a black-box function. The set of parameters may come from a parameter space, for example a multi-dimensional parameter space having a dimensionality corresponding to the number of parameters. The method 100 may comprise optimizing 110 a set of parameters to be used for the target function by evaluating the target function using different points in the parameter space as input, each point representing a different set of parameters, to obtain respective outputs of the target function. The optimizing 110 may comprise, as part of an iterative process, selecting 120 a new point in the parameter space based on a dataset which comprises, as respective pairwise data tuples, i) previous inputs to the target function and ii) previous outputs from the target function, evaluating 130 the target function using the new point as new input to obtain a new output of the target function, and adding 140 the new input and the new output to the dataset, thereby incrementally augmenting the dataset. The iterative optimization may be repeated until a stopping criterion is reached 160. The stopping criterion may be based on an upper confidence bound function and a lower confidence bound function. Each of said confidence bound functions may be configured to determine a confidence bound for a point in the parameter space using the dataset as input. The method may comprise evaluating 150 the stopping criterion by determining an optimum of an upper confidence bound over all of the parameter space using the upper confidence bound function and determining the optimum of a lower confidence bound over all of the parameter space using the lower confidence bound function. The optimum may be a maximum or a minimum. The stopping criterion may be reached when a difference between the optimum of the upper confidence bound and the optimum of the lower confidence bound reaches or falls below an accuracy target. When the stopping criterion is not reached, the steps 120, 130, 140 may be repeated in a next iteration 170. Once the stopping criterion is reached, a set of parameters may be output 180, for example a most recently evaluated set of parameters or an optimum set of parameters which may be obtained by evaluating or optimizing the upper or lower confidence bound functions.

With continued reference to the Bayesian optimization, such Bayesian optimization, of which Fig. 1 shows a flow-chart, may also be described in pseudo-code as follows:

    1. $t := 0$; $D_0 := \{\}$ (empty set; no data observed yet)
    2. repeat
    3. select new $x_{t+1}$ by optimizing an acquisition function $\alpha$:

$$x_{t+1} := argmax_{x \in X}\ \alpha(x; D_t).$$

    4. query the objective function (black box) to obtain $y_{t+1}$.
    5. augment dataset $D_{t+1} := D_t \cup \{(x_{t+1}, y_{t+1})\}$
    6. $t := t + 1$ (go to next timestep)
    7. until stopping criterion reached
    8. (optional) return (an estimate of) a global optimizer $x^*$ and/or (an estimate of) the global optimum $y^*$.

Here, $t$ may refer to a timestep (e.g., an iteration step), $D_t$ may be a dataset of function inputs and function outputs which contains all pairs of previous inputs and previous outputs up until and including those of timestep $t$, $x_{t+1}$ may be a new point in the parameter space to be evaluated in a next iteration, and $y_{t+1}$ may be a new output of the target function in the next iteration given $x_{t+1}$ as input.

The following describes various improvements to the stopping criterion, e.g., to step 7 of the pseudo-code. Herein, the representation of the Bayesian optimization by pseudo-code is also referred to as "BO-algorithm". Furthermore, the following refers to the stopping criterion being optimized by maximizing the respective confidence bound functions. It will be appreciated that, in the case of minimizing the target function, instead of maximizing these functions, the stopping criterion may also be optimized by minimizing the respective confidence bound functions.

The stopping criterion may be based on the following function $\bar{g}_t = \max_{x \in X} UCB_{t,\delta}(x) - \max_{x \in X} LCB_{t,\delta}(x)$, in which $\bar{g}_t$ may also be referred to as 'maximum plausible gap' at timestep $t$. In this function, the maximization over the $LCB_{t,\delta}(x)$ may run over all possible design points $x \in X$, instead of only running over the previously seen ones $x \in \{x_1, x_2, ..., x_t\}$. The stopping criterion may in some embodiments comprise hyperparameters such as a confidence level $\delta \in (0,1)$ and an accuracy target $\varepsilon_{goal} \in (0, \infty)$. The stopping criterion may be $\bar{g}_t \leq \varepsilon_{goal}$. Both hyperparameters may be selected before starting the algorithm. The hyperparameter $\delta$ may specify an upper bound on the probability (over the observed data) that the BO algorithm is stopped even though the gap between the maximized $LCB_{t,\delta}(x)$ and the global optimum of the target function is larger than $\varepsilon_{goal}$. Thus, $\delta$ may be considered as a maximal failure probability since otherwise the BO algorithm may be continued if the gap between the maximized $LCB_{t,\delta}(x)$ and the global optimum is larger than $\varepsilon_{goal}$.

At each execution of line 7 in the BO-algorithm, or regularly, e.g., every nth execution thereof, the maximum plausible gap may be computed as follows:

$$\bar{g}_t = \max_{x \in X} UCB_{t,\delta}(x; D_t) - \max_{x \in X} LCB_{t,\delta}(x; D_t)$$

based on the data $D_t$ that have been obtained so far. Here, UCB and LCB may be any type of upper/lower confidence bounds on the target function value at the point $x$, given the data $D_t$ observed so far. The stopping criterion may be fulfilled if $\bar{g}_t < \varepsilon_{goal}$, e.g., if the guaranteed maximal gap to the true global optimum (which may be guaranteed up to probability $\delta$) is below the accuracy target $\varepsilon_{goal}$. As an alternative, instead of a fixed pre-specified $\varepsilon_{goal}$, an adaptive accuracy target may be used, for example an adaptive accuracy target $s_t$ as defined in [1].

Optionally, as described in line 8 of the BO-algorithm, an estimate of a global optimizer such as

$$x^* = \operatorname*{argmax}_{x \in X} LCB_{t,\delta}(x; D_t)$$

may be returned if the stopping criterion is reached. Optionally, in addition to returning $x^*$, any estimate of a corresponding objective value $y^*$ between $LCB_{t,\delta}(x^*; D_t)$ and $UCB_{t,\delta}(x^*; D_t)$ may be returned.

In some examples, evaluating the upper respectively the lower confidence bound function comprises determining a maximum respectively a minimum value of a surrogate model, wherein the surrogate model is configured to approximate the target function, wherein determining the maximum respectively the minimum value comprises maximizing respectively minimizing the surrogate model over a set of feasible surrogate functions. The surrogate model may for example be a function from a reproducing kernel Hilbert space (RKHS), as also used for Gaussian Processes.

In another example, the surrogate model may be a linear model. The linear model may be defined as an inner product of a feature vector and a parameter vector. The feature vector may be defined as a transformation of an input point into a feature space. The parameter vector may weigh features in the feature space to obtain an approximated output of the target function. A feasible surrogate function may correspond to the inner product of the feature vector and a feasible parameter vector. The surrogate model may thus be optimized by determining a maximum respectively a minimum over a set of inner products of the feature vector and a respective feasible parameter vector.

In a specific example, the following upper confidence bound function and lower bound function may be used:

$$UCB_{t,\delta}(x; D_t) = \max_{\theta \in \mathbb{R}^d} \phi(x)^\top \theta \quad \text{s.t.} \, ||\Phi_t \theta - r_t||_2 \le R_{\mathrm{MM},t} \quad \text{and} \quad ||\theta||_2 \le B.$$

$$LCB_{t,\delta}(x; D_t) = \min_{\theta \in \mathbb{R}^d} \phi(x)^\top \theta \quad \text{s.t.} \, ||\Phi_t \theta - r_t||_2 \le R_{\mathrm{MM},t} \quad \text{and} \quad ||\theta||_2 \le B.$$

Here, the optimizations run over a set of feasible parameter vectors $\theta$:

$$\theta \in \Theta_t = \{\theta \in \mathbb{R}^d \,|\, ||\Phi_t \theta - r_t||_2 \le R_{\mathrm{MM},t} \text{ and } ||\theta||_2 \le B\}, \text{ where } \Phi_t = \big(\phi(x_1), ..., \phi(x_t)\big)^\top \in \mathbb{R}^{t \times d}$$ may denote the matrix of previous design feature vectors and $r_t = (y_1, ..., y_t)^T$ may denote the vector of previously measure function values. The parameter vectors $\theta \in \Theta_t$ may represent a set of feasible surrogate functions $\phi(x)^\top \theta$ which each approximate the target function, $||\Phi_t \theta - r_t||_2 \le R_{\mathrm{MM},t}$ may represent a consistency constraint which limits the set of feasible surrogate functions to those surrogate functions which generate outputs which are consistent with the previous outputs from the target function, and $||\theta||_2 \le B$ may represent an overfitting constraint which restricts a norm, e.g. a Euclidian norm, of the surrogate function or its parameter vector to remain within a predetermined limit.

These formulations of the UCB and LCB may apply to (stochastic) linear bandits, which may refer to Bayesian optimization where a finite-dimensional kernel is used as a surrogate model for the target function. This finite-dimensional kernel may be specified by the feature function $\phi$, which may associate a d-dimensional feature vector $\phi(x)$ to each set of parameters $x$. The hyperparameter $B$ may be an upper bound on the complexity of the (unknown) target function. Furthermore, the quantity $R_{\mathrm{MM},t}$ may contain a hyperparameter $\sigma$, which represents an upper bound on the measurement noise when evaluating the black-box function. The quantity $R_{\mathrm{MM},t}$ may further contain the confidence level $\delta$ from above as a hyperparameter. The vector $r_t$ may contain the previously measured function values, e.g., $r_t = (y_1, y_2, ..., y_t)$. $R_{\mathrm{MM},t}$ may e.g. be defined as

$$R_{\mathrm{MM},t} = \sqrt{(\mu_t - r_t)^\top \left(\mathbb{I}_t + \frac{T_t}{\sigma^2}\right)^{-1} (\mu_t - r_t) + \sigma^2 \log \det \left(\mathbb{I}_t + \frac{T_t}{\sigma^2}\right) + 2\sigma^2 \log \frac{1}{\delta}} \, ,$$

Where $\mathbb{I}_t$ denotes the $t \times t$ identity matrix and the vectors $\mu_t$ and positive semidefinite matrix $T_t$ may be selected in any way compatible with the time-ordering: The $k$-the element of $\mu_t$ as well as the $k$-th row and column of $T_t$ may depend only on the design points $x_1, x_2, ..., x_k$ and on the measurements $y_1, y_2, ... , y_{k-1}$. In words, $\mu_t$ and $T_t$ may be probabilistic predictors of the measurements $y_i$ ($i = 1, ... , t$), given that they have only seen the previous measurements $y_1, ... , y_{i-1}$.

The Bayesian optimization may also model the target function as a kernel bandit (i.e., a function from a reproducing kernel Hilbert space, usually infinite-dimensional) with kernel function $k$, instead of as a linear (finite-dimensional) bandit. In such examples, the following analogous formula may be used for the upper confidence bound function and lower bound function:

$$UCB_{t,\delta}(x; D_t) = \max_{v \in \mathbb{R}^{t+1}} v_{t+1} \quad s.t. \quad ||(v_1, v_2, ..., v_t)^T - r_t||_2 \leq R_{\mathrm{MM},t} \quad and \quad v^T K^{-1} v$$

$$\leq B,$$

$$LCB_{t,\delta}(x; D_t) = \min_{v \in \mathbb{R}^{t+1}} v_{t+1} \quad s.t. \quad ||(v_1, v_2, ..., v_t)^T - r_t||_2 \leq R_{\mathrm{MM},t} \quad and \quad v^T K^{-1} v$$

$$\leq B,$$

where $K \in \mathbb{R}^{(t+1) \times (t+1)}$ denotes the kernel matrix built by evaluating the kernel function $k$ on all pairs built from the points $(x_1, x_2, ... , x_t, x)$, and $R_{\mathrm{MM},t}$ denotes a quantity analogous to the linear bandit case above.

It is noted that the optimizations required to compute $UCB_{t,\delta}(x; D_t)$ and $LCB_{t,\delta}(x; D_t)$ may be respective convex optimization problems (over the finite-dimensional variables $\theta \in \mathbb{R}^d$ or over the vector $v \in \mathbb{R}^{t+1}$ in the kernel bandit case above). These optimization problems may be efficiently and certifiably solved with convex optimization libraries, such as Python-based CVXPY (https://www.cvxpy.org/). In addition, with libraries such as cvxpylayers (https://github.com/cvxgrp/cvxpylayers), the gradients of the optimal values with respect to the design point $x$ (in the case where $x \in X \subseteq \mathbb{R}^n$ comes from a continuous set) may be computed. Such gradients may be used to compute the further

$$\bar{g}_t = \max_{x \in X} UCB_{t,\delta}(x; D_t) - \max_{x \in X} LCB_{t,\delta}(x; D_t)$$

optimizations over $x \in X$ in in a gradient-based way, possibly augmented with additional re-starts.

As another alternative to the UCB and LCB functions described above, an analytic UCB may be used, with the LCB being identical except that 'max' is replaced by 'min' and the plus sign in front of the square root is replaced by a minus sign

$$UCB_{t,\delta}(x; D_t) = \max_{\theta \in \Theta_t}\{\phi(x)^\top \theta\} \leq \phi(a)^\top \hat{\theta}_{\alpha,t} + R_{\mathrm{AMM},t}\sqrt{\phi(x)^\top (\Phi_t^\top \Phi_t + \alpha\mathbb{I})^{-1}\phi(a)},$$

where $\hat{\theta}_{\alpha,t} = (\Phi_t^\top \Phi_t + \alpha\mathbb{I})^{-1}\Phi_t^\top r_t$, $R_{\mathrm{AMM},t}^2 = R_{\mathrm{MM},t}^2 + \alpha B^2 - r_t^\top r_t + r_t^\top \Phi_t(\Phi_t^\top \Phi_t + \alpha\mathbb{I})^{-1}\Phi_t^\top r_t$.

These UCB and LCB functions may represent relaxed versions of the upper respectively the lower confidence bound function which may be evaluated analytically, but may require an additional hyperparameter $\alpha > 0$ that can be chosen arbitrarily but which indeed may have to be chosen before evaluating the UCB and the LCB functions.

Alternatively, known UCB or LCB functions may be used from the prior art, e.g., as described in "Improved Algorithms for Linear Stochastic Bandits" by Yasin Abbasi-Yadkori, Dávid Pál and Csaba Szepesvári or from Srinivas et al. (2010).

In some examples, the upper confidence bound $UCB_{t,\delta}(x)$ may be used as an acquisition function for Bayesian optimization, e.g., in step 3 of the pseudo-code:

$$x_{t+1} := argmax_{x \in X} \; UCB_{t,\delta}(x; D_t).$$

It will be appreciated that the steps of any of the methods described in the present disclosure may be performed in any suitable order, e.g., consecutively, simultaneously, or a combination thereof, subject to a particular order being necessitated, e.g., by input/output relations. The method(s) may be implemented on a computer as a computer-implemented method, as dedicated hardware, or as a combination of both. As also illustrated in **Fig. 2,** instructions for the computer, e.g., executable code, may be stored on a computer-readable medium 400, e.g., in the form of a series 410 of machine-readable physical marks and/or as a series of elements having different electrical, e.g., magnetic, or optical properties or values. The computer-readable medium 400 may be a transitory or non-transitory computer-readable medium. Examples of computer-readable mediums include memory devices, optical storage devices, integrated circuits, etc. By way of example, Fig. 2 shows a memory card 400.

**Fig. 3** shows a processor system 200 configured to perform Bayesian optimization in respect of a set of parameters of a target function. The processor system 200 may comprise a processor 210 and a memory (not explicitly shown) which may store data representing instructions to cause processor 210 to perform any of the presently disclosed methods. The processor system 200 may further comprise a data storage interface 220 to a data storage 230. The data storage 230 may store data during the Bayesian optimization, such as historical data from evaluations of the target function.

The target function is shown in Fig. 3 symbolically as a box 300. The processor system 200 may comprise an interface 240 to configure the target function 300 with a set of parameters 310 to perform function evaluation during the Bayesian optimization. Alternatively, or additionally, the interface 240 may be used to configure the target function 300 with a set of parameters 310 after the Bayesian optimization has stopped, e.g., with an optimal or optimized set of parameters. The interface 240 may be an interface to a device or system which participates in the execution of the target function 300, or to a device or system which has one or more operational characteristics which represent the target function, e.g., one or more control characteristics. In a specific example, if the target function 300 is a computer-implemented function, the interface 240 may be a software interface, e.g., an application programming interface (API), a network interface, etc. In some examples, the interface 240 may be a control interface to the device or system participating in the execution of the target function 300. The processor system 200 may further comprise an interface 250 to access an output 320 of the target function 300. The interface 250 may for example be a same type of interface as described for the interface 240. In some examples, the interface 240 may be a sensor interface to a sensor capturing an output 320 of the target function 300. In some examples, the target function 300 may be executed by the processor system 200, in which cases the interfaces 240, 250 may be internal interfaces of the processor system.

In alternative embodiments, the interfaces 240, 250 may be output and input parts of user interface, e.g., a graphical user interface. This way, the processor system 200 may output the set of parameters 310 to a user, the user may configure the target function 300 with the set of parameters, execute the target function, and then enter a (characterization of an) output 320 of the target function 300 into the user interface.

In a specific example, the target function may be a manufacturing process. In such an example, the set of parameters may define process parameters of the manufacturing process and/or operational parameters of machinery used in the manufacturing process, and evaluating the manufacturing process may comprise executing the manufacturing process with the set of parameters and characterizing the execution of the manufacturing process and/or a manufactured product of the manufacturing process.

In another specific example, the target function may be the training and/or evaluation of a machine learning model. In such an example, the set of parameters may define hyperparameters for the training, and evaluating the training of the machine learning model may comprise training the machine learning model using the hyperparameters and characterizing the execution of the training and/or the trained machine learning model, e.g. by characterizing/evaluating it on test or validation data.

In another specific example, the target function may be the configuration of a simulation model of a physical system and/or the evaluation/characterization of its goodness, for example a digital twin of the physical system. In another specific example, the target function may be a simulation model of a further and more complex simulation model. In such examples, the set of parameters may define operational parameters of the simulation model, and evaluating the simulation model may comprise executing the simulation model using the operational parameters and characterizing a performance and/or an accuracy of the simulation model.

In another specific example, the processor system 200 may be configured as a control system to control a technical system, such as a computer-controlled machine, for example a robotic system, a vehicle, a domestic appliance, a power tool, a manufacturing machine, a personal assistant, or an access control system. Namely, the processor system 200 may be configured to use Bayesian optimization to find the next control inputs for the technical system based on sensor data obtained from one or more sensors. The sensor data may be indicative of one or more operational characteristics of the technical system. Specifically, the processor system 200 may, in each control step, select control inputs to be input into the technical system for the next step, where the control inputs may be based on a Bayesian Optimization that uses sensor measurements from previous steps. More precisely, the processor system 200 may iteratively perform a Bayesian Optimization (in respect of a set of parameters of the technical system) of a target function characterizing the system performance, such as a technical performance indicator (TPI), that has been measured (e.g., as measured outputs 320) or has been derived from sensor measurements 320 in previous control steps/rounds based on control inputs 310 into the technical system in previous steps/rounds. The target function, such as the TPI, may indicate closeness to a desired or target state, or indicators such as performance, accuracy, failure rate, or efficiency of the technical system. The optimized set of parameters of the technical system in each step may then be used to derive control inputs for the next step.

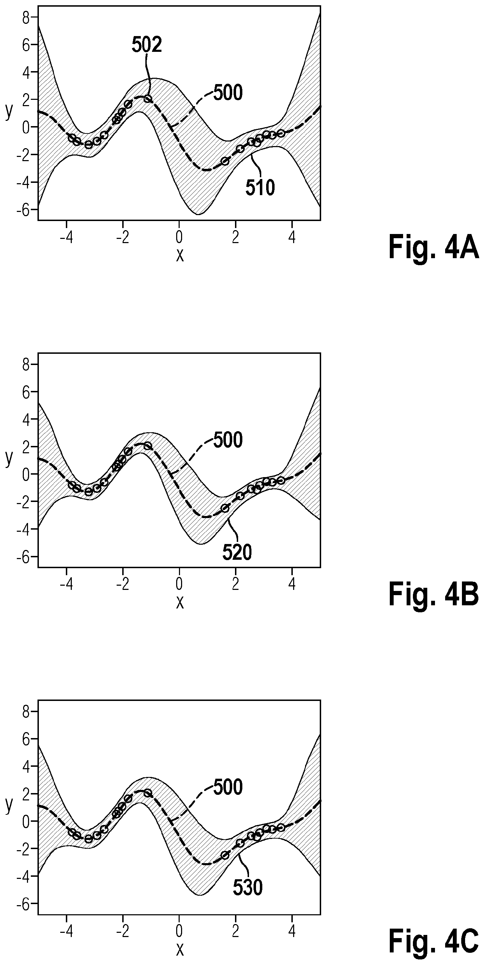

**Fig. 4** shows in subfigures (a), (b), and (c) plots of confidence bounds 510-530 obtained by using different confidence bound functions. In each of these subfigures, the input and output to the target function are inputs x, shown on the horizontal axis, and outputs y, shown on the vertical axis. Points 502 show previously obtained input-output data pairs of the underlying target function 500 (which is shown in dashed form to indicate that this target function 500 may be unknown, e.g., in case of a black-box function). Subfigure (a) shows a confidence bound 510 obtained by a reference method, being in this example "Improved Algorithms for Linear Stochastic Bandits" by Yasin Abbasi-Yadkori, Dávid Pál and Csaba Szepesvári. Subfigure (b) shows a confidence bound 520 obtained by convex optimization of the presently disclosed confidence bound functions which are formulated as convex optimization problems, whereas subfigure (c) shows a confidence bound 530 obtained by as an analytical solution to the presently disclosed confidence bound functions which are formulated analytically. It can be seen that confidence bounds 520, 530 are visibly closer to the target function 500 than confidence bound 510.

In general, the processor system described in this specification may comprise one or more (micro)processors which execute appropriate software. The software implementing the functionality of the processor system may have been downloaded and/or stored in a corresponding memory or memories, e.g., in volatile memory such as RAM or in non-volatile memory such as Flash. Alternatively, the processor system may be implemented in the form of programmable logic, e.g., as a Field-Programmable Gate Array (FPGA). Any input and/or output interfaces may be implemented by respective hardware and/or software interfaces. In general, the processor system, input interfaces, and/or output interfaces may each be implemented in the form of a circuit or circuitry. The processor system may also be implemented in a distributed manner, e.g., involving different devices or apparatus, for example one or more cloud-based servers.

Examples, embodiments or optional features, whether indicated as non-limiting or not, are not to be understood as limiting the invention as claimed.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "comprise" and its conjugations does not exclude the presence of elements or stages other than those stated in a claim. The article "a" or "an" preceding an element does not exclude the presence of a plurality of such elements. Expressions such as "at least one of" when preceding a list or group of elements represent a selection of all or of any subset of elements from the list or group. For example, the expression, "at least one of A, B, and C" should be understood as including only A, only B, only C, both A and B, both A and C, both B and C, or all of A, B, and C. The invention may be implemented by means of hardware comprising several distinct elements, and by means of a suitably programmed computer. In the device claim enumerating several means, several of these means may be embodied by one and the same item of hardware. The mere fact that certain measures are recited in mutually different dependent claims does not indicate that a combination of these measures cannot be used to advantage.

## Claims

1. A computer-implemented method (100) of performing Bayesian optimization in respect of a set of parameters of a target function, such as a black-box function, wherein the set of parameters is selected from a parameter space, wherein the method comprises optimizing the set of parameters by evaluating the target function using different points in the parameter space as input, each point representing a different set of parameters, to obtain respective outputs of the target function,

   wherein said optimizing (110) comprises iteratively:

   - selecting (120) a new point in the parameter space based on a dataset which comprises, as respective pairwise data tuples, i) previous inputs to the target function and ii) previous outputs from the target function;
   - evaluating (130) the target function using the new point as new input to obtain a new output of the target function; and
   - adding (140) the new input and the new output to the dataset, thereby incrementally augmenting the dataset;

   wherein said iterative optimization is repeated (170) until a stopping criterion is reached (160), wherein the stopping criterion is based on an upper confidence bound function and a lower confidence bound function, wherein each of said confidence bound functions is configured to determine a confidence bound for a point in the parameter space using the dataset as input, wherein the method comprises evaluating (150) the stopping criterion by determining an optimum of an upper confidence bound over all of the parameter space by evaluating the upper confidence bound function and determining the optimum of a lower confidence bound over all of the parameter space by evaluating the lower confidence bound function, wherein the optimum is a maximum or a minimum, wherein the stopping criterion is reached when a difference between the optimum of the upper confidence bound and the optimum of the lower confidence bound reaches or falls below an accuracy target.

2. The method (100) according to claim 1, wherein evaluating the upper respectively the lower confidence bound function comprises determining a maximum respectively a minimum value of a surrogate model, wherein the surrogate model is configured to approximate the target function, wherein determining the maximum respectively the minimum value comprises maximizing respectively minimizing the surrogate model over a set of feasible surrogate functions.

3. The method (100) according to claim 2, wherein the surrogate model is a linear model, wherein the linear model is defined as an inner product of a feature vector and a parameter vector, wherein the feature vector defines a transformation of an input point into a feature space, wherein the parameter vector weighs features in the feature space to obtain an approximated output of the target function, wherein a surrogate function corresponds to the inner product of the feature vector and a parameter vector, wherein a feasible surrogate function corresponds to the inner product of the feature vector and a feasible parameter vector.

4. The method (100) according to claim 2 or 3, wherein the set of feasible surrogate functions is defined as the set of surrogate functions which satisfy both a consistency constraint and an overfitting constraint, wherein the consistency constraint limits the set of feasible surrogate functions to those surrogate functions which generate outputs which are consistent with the previous outputs from the target function, wherein the overfitting constraint restricts a norm, for example a Euclidian norm, of the surrogate function or of the parameter vector to remain within a predetermined limit.

5. The method (100) according to claim 4, wherein the set of feasible surrogate functions is redetermined at each iteration using the previous outputs from the target function.

6. The method (100) according to any one of claims 2 to 5, further comprising determining the maximum respectively the minimum value of the surrogate model numerically by using a convex optimization technique.

7. The method (100) according to any one of claims 2 to 5, further comprising determining a maximum respectively a minimum value of the surrogate model using an analytical expression for a relaxed version of the upper respectively the lower confidence bound function.

8. The method (100) according to any one of claims 1 to 7, further comprising selecting, in an iteration of the iterative optimization, the new point in the parameter space using the upper confidence bound function if the optimum is the maximum or using the lower confidence bound function if the optimum is the minimum.

9. The method (100) according to any one of claims 1 to 8, further comprising, when the stopping criterion is reached (160), outputting (180) an estimate of an optimum point in the parameter space, wherein the estimate of the optimum point is obtained by determining the maximum of the lower confidence bound over all of the parameter space using the lower confidence bound function if the optimum is the maximum or by determining the minimum of the upper confidence bound over all of the parameter space using the upper confidence bound function if the optimum is the minimum.

10. The method (100) according to claim 9, further comprising outputting (180) an estimate of the output of the target function for the optimum point as input, wherein the estimate of the output is obtained by evaluating the lower confidence bound function and the upper confidence bound function for the optimum point, wherein the estimate of the output is preferably outputted in form of the value of the lower confidence bound function at the optimum point and the value of the upper confidence bound at the optimum point or in form of an intermediate value between the values of the lower confidence bound and the upper confidence bound functions at the optimum point.

11. The method (100) according to any one of claims 1 to 10, wherein the accuracy target is a fixed accuracy target or an adaptively chosen accuracy target, for example in form of an estimate of a current accuracy of an approximation of the target function.

12. The method (100) according to any one of claims 1 to 11, further comprising configuring the target function with a set of parameters which is obtained from the iterative optimization, and optionally, executing the target function configured with the set of parameters.

13. The method (100) according to any one of claims 1 to 12, wherein the method is used to determine a set of parameters for, as the target function:

- execution of a manufacturing process, wherein the set of parameters defines process parameters of the manufacturing process and/or operational parameters of machinery used in the manufacturing process, wherein evaluating the manufacturing process comprises executing the manufacturing process with the set of parameters and characterizing the execution of the manufacturing process and/or a manufactured product of the manufacturing process;
- training of a machine learning model, wherein the set of parameters defines hyperparameters for the training of the machine learning model, wherein evaluating the training of the machine learning model comprises training the machine learning model using the hyperparameters and characterizing the execution of the training and/or the trained machine learning model;
- configuration of a simulation model of a physical system, for example a digital twin of the physical system, or a simulation model of a further and more complex simulation model, wherein the set of parameters defines operational parameters of the simulation model, wherein evaluating the simulation model comprises executing the simulation model using the operational parameters and characterizing a performance and/or an accuracy of the simulation model.

14. A transitory or non-transitory computer-readable medium (400) comprising data (410) representing a computer program, the computer program comprising instructions for causing a processor system to perform the method according to any one of claims 1 to 13.

15. A processor system (200) comprising a memory and one or more processors (210), wherein the memory comprises instructions for causing the one or more processors to perform the method according to any one of claims 1 to 13.

**Amended claims in accordance with Rule 137(2) EPC.**

1. A computer-implemented method (100) of performing Bayesian optimization in respect of a set of parameters of a target function, such as a black-box function, wherein the set of parameters is selected from a parameter space, wherein the method comprises optimizing the set of parameters by evaluating the target function using different points in the parameter space as input, each point representing a different set of parameters, to obtain respective outputs of the target function,

wherein said optimizing (110) comprises iteratively:

- selecting (120) a new point in the parameter space based on a dataset which comprises, as respective pairwise data tuples, i) previous inputs to the target function and ii) previous outputs from the target function;
- evaluating (130) the target function using the new point as new input to obtain a new output of the target function; and
- adding (140) the new input and the new output to the dataset, thereby incrementally augmenting the dataset;

wherein said iterative optimization is repeated (170) until a stopping criterion is reached (160), wherein the stopping criterion is based on an upper confidence bound function and a lower confidence bound function, wherein each of said confidence bound functions is configured to determine a confidence bound for a point in the parameter space using the dataset as input, wherein the method comprises evaluating (150) the stopping criterion by determining an optimum of an upper confidence bound over all of the parameter space by evaluating the upper confidence bound function and determining the optimum of a lower confidence bound over all of the parameter space by evaluating the lower confidence bound function, wherein the optimum is a maximum or a minimum, wherein the stopping criterion is reached when a difference between the optimum of the upper confidence bound and the optimum of the lower confidence bound reaches or falls below an accuracy target, wherein the method is used to determine a set of parameters for, as the target function, execution of a manufacturing process, wherein the set of parameters defines process parameters of the manufacturing process and/or operational parameters of machinery used in the manufacturing process, wherein evaluating the manufacturing process comprises executing the manufacturing process with the set of parameters and characterizing the execution of the manufacturing process and/or a manufactured product of the manufacturing process.

2. The method (100) according to claim 1, wherein evaluating the upper respectively the lower confidence bound function comprises determining a maximum respectively a minimum value of a surrogate model, wherein the surrogate model is configured to approximate the target function, wherein determining the maximum respectively the minimum value comprises maximizing respectively minimizing the surrogate model over a set of feasible surrogate functions.

3. The method (100) according to claim 2, wherein the surrogate model is a linear model, wherein the linear model is defined as an inner product of a feature vector and a parameter vector, wherein the feature vector defines a transformation of an input point into a feature space, wherein the parameter vector weighs features in the feature space to obtain an approximated output of the target function, wherein a surrogate function corresponds to the inner product of the feature vector and a parameter vector, wherein a feasible surrogate function corresponds to the inner product of the feature vector and a feasible parameter vector.

4. The method (100) according to claim 2 or 3, wherein the set of feasible surrogate functions is defined as the set of surrogate functions which satisfy both a consistency constraint and an overfitting constraint, wherein the consistency constraint limits the set of feasible surrogate functions to those surrogate functions which generate outputs which are consistent with the previous outputs from the target function, wherein the overfitting constraint restricts a norm, for example a Euclidian norm, of the surrogate function or of the parameter vector to remain within a predetermined limit.

5. The method (100) according to claim 4, wherein the set of feasible surrogate functions is redetermined at each iteration using the previous outputs from the target function.

6. The method (100) according to any one of claims 2 to 5, further comprising determining the maximum respectively the minimum value of the surrogate model numerically by using a convex optimization technique.

7. The method (100) according to any one of claims 2 to 5, further comprising determining a maximum respectively a minimum value of the surrogate model using an analytical expression for a relaxed version of the upper respectively the lower confidence bound function.

8. The method (100) according to any one of claims 1 to 7, further comprising selecting, in an iteration of the iterative optimization, the new point in the parameter space using the upper confidence bound function if the optimum is the maximum or using the lower confidence bound function if the optimum is the minimum.

9. The method (100) according to any one of claims 1 to 8, further comprising, when the stopping criterion is reached (160), outputting (180) an estimate of an optimum point in the parameter space, wherein the estimate of the optimum point is obtained by determining the maximum of the lower confidence bound over all of the parameter space using the lower confidence bound function if the optimum is the maximum or by determining the minimum of the upper confidence bound over all of the parameter space using the upper confidence bound function if the optimum is the minimum.

10. The method (100) according to claim 9, further comprising outputting (180) an estimate of the output of the target function for the optimum point as input, wherein the estimate of the output is obtained by evaluating the lower confidence bound function and the upper confidence bound function for the optimum point, wherein the estimate of the output is preferably outputted in form of the value of the lower confidence bound function at the optimum point and the value of the upper confidence bound at the optimum point or in form of an intermediate value between the values of the lower confidence bound and the upper confidence bound functions at the optimum point.

11. The method (100) according to any one of claims 1 to 10, wherein the accuracy target is a fixed accuracy target or an adaptively chosen accuracy target, for example in form of an estimate of a current accuracy of an approximation of the target function.

12. The method (100) according to any one of claims 1 to 11, further comprising configuring the target function with a set of parameters which is obtained from the iterative optimization, and optionally, executing the target function configured with the set of parameters.

13. A transitory or non-transitory computer-readable medium (400) comprising a computer program, the computer program comprising instructions which, when executed by a processor system, cause the processor system to perform the method according to any one of claims 1 to 12.

14. A processor system (200) comprising a memory and one or more processors (210), wherein the memory comprises instructions which, when executed by the one or more processors, cause the one or more processors to perform the method according to any one of claims 1 to 12.

Fig. 1

Fig. 2

Fig. 3

Fig. 4A

Fig. 4B

Fig. 4C

## EUROPEAN SEARCH REPORT

**Application Number**

EP 24 16 4421

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ANASTASIA MAKAROVA ET AL: "Automatic Termination for Hyperparameter Optimization", ARXIV.ORG, CORNELL UNIVERSITY LIBRARY, 201 OLIN LIBRARY CORNELL UNIVERSITY ITHACA, NY 14853, 22 July 2022 (2022-07-22), XP091277216, * abstract * * sections 2 and 3.2 * * algorithm 1 on page 13 * | 1-15 | INV. G06N20/00 G06N7/01 G06N5/01 |
| A | Unknown Unknown: "Bayesian optimization on a polynomial regression as the surrogate model", , 9 February 2023 (2023-02-09), pages 1-2, XP093198282, StackExchange Retrieved from the Internet: URL:https://stats.stackexchange.com/questions/602465/bayesian-optimization-on-a-polynomial-regression-as-the-surrogate-model [retrieved on 2024-08-23] * the whole document * | 3 | |

**TECHNICAL FIELDS SEARCHED (IPC)**

G06N

The present search report has been drawn up for all claims

| Place of search | Date of completion of the search | Examiner |
|---|---|---|
| The Hague | 23 August 2024 | Theissing, Simon |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **YASIN ABBASI-YADKORI** ; **DÁVID PÁL** ; **CSABA SZEPESVÁRI**. *Improved Algorithms for Linear Stochastic Bandits*